(19) Europäisches Patentamt
European Patent Office
Office européen des brevets

(11) **EP 3 839 837 B1**

(12) **FASCICULE DE BREVET EUROPEEN**

(45) Date de publication et mention de la délivrance du brevet:
**05.08.2026 Bulletin 2026/32**

(21) Numéro de dépôt: **20213330.2**

(22) Date de dépôt: **11.12.2020**

(51) Classification Internationale des Brevets (IPC):
**G06N 10/40** (2022.01)

(52) Classification Coopérative des Brevets (CPC):
**G06N 10/40**

(54) **DISPOSITIF QUANTIQUE A QUBIT DE SPIN LU PAR MESURE D'IMPEDANCE**

QUBIT-QUANTENVORRICHTUNG MIT DURCH IMPEDANZMESSUNG AUSGELESENER SPINRATE

QUANTUM DEVICE WITH SPIN QUBIT READ BY MEASURING IMPEDANCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2019 FR 1914651**

(43) Date de publication de la demande:
**23.06.2021 Bulletin 2021/25**

(73) Titulaire: **Commissariat à l'Energie Atomique et aux Energies Alternatives
75015 Paris (FR)**

(72) Inventeurs:
• **LE GUEVEL, Loïck**
**38054 Grenoble Cedex 09 (FR)**
• **BILLIOT, Gérard**
**38054 Grenoble Cedex 09 (FR)**
• **JANSEN, Aloysius**
**38054 Grenoble Cedex 09 (FR)**
• **PILLONNET, Gaël**
**38054 Grenoble Cedex 09 (FR)**

(74) Mandataire: **Santarelli
Tour Trinity
1 bis Place de la Défense
92400 Courbevoie (FR)**

(56) Documents cités:
• **BARDIN JOSEPH C ET AL: "Design and Characterization of a 28-nm Bulk-CMOS Cryogenic Quantum Controller Dissipating Less Than 2 mW at 3 K", IEEE JOURNAL OF SOLID-STATE CIRCUITS, IEEE, USA, vol. 54, no. 11, 1 November 2019 (2019-11-01), pages 3043 - 3060, XP011751678, ISSN: 0018-9200, [retrieved on 20191022], DOI: 10.1109/JSSC.2019.2937234**
• **DE FRANCESCHI S ET AL: "SOI technology for quantum information processing", 2016 IEEE INTERNATIONAL ELECTRON DEVICES MEETING (IEDM), IEEE, 3 December 2016 (2016-12-03), XP033054973, DOI: 10.1109/ IEDM.2016.7838409**
• **BARTHELEMY H ET AL: "NMOS transistors based Karsilayan & Schaumann gyrator: lowpass and bandpass filter applications'", MIDWEST SYMPOSIUM ON CIRCUITS AND SYSTEMS. CAIRO, EGYPT, DEC. 27 - 30, 2003; [MIDWEST SYMPOSIUM ON CIRCUITS AND SYSTEMS], PISCATAWAY, NJ, IEEE, US, vol. 1, 27 December 2003 (2003-12-27), pages 97 - 100, XP010867399, ISBN: 978-0-7803-8294-7, DOI: 10.1109/MWSCAS.2003.1562227**
• **HEORHII BOHUSLAVSKYI: "Cryogenic electronics and quantum dots on silicon-on-insulator for quantum computing", 14 December 2018 (2018-12-14), XP055724719, Retrieved from the Internet <URL:https://tel.archives-ouvertes. fr/tel-02183484/document> [retrieved on 20200828]**

**Description**

**DOMAINE TECHNIQUE**

L'invention concerne le domaine de l'électronique quantique et de l'informatique quantique. L'invention concerne plus particulièrement un dispositif quantique dans lequel la lecture de spins d'électrons ou de trous au sein de puits quantiques sur technologies semi-conductrices (GaAs, Silicium, etc.), ou lecture de qubits, est réalisée par mesure d'impédance.

**ÉTAT DE LA TECHNIQUE ANTÉRIEURE**

L'informatique quantique est basée sur l'utilisation d'un état quantique à deux niveaux mesurables comme vecteur d'information, appelé qubit, et des lois de la mécanique quantique (superposition, intrication, mesure) afin d'exécuter des algorithmes. Ces algorithmes quantiques ont le potentiel de surpasser certaines classes d'algorithmes classiques, par exemple pour réaliser des factorisations en nombre premiers dans le domaine de la cryptographie ou pour résoudre des problèmes d'optimisation. Indépendamment des technologies utilisés, un ordinateur quantique sera composé de plusieurs milliers de qubits sur lesquels trois types d'opérations seront réalisées : l'initialisation des qubits dans un état connu, la manipulation des qubits et la lecture de ces qubits. L'implémentation d'un tel ordinateur quantique nécessite également la mise en place de codes correcteurs qui requièrent des manipulations et lectures rapides, massives et répétées sur l'ensemble des qubits afin de lutter contre la perte d'information.

Le document DE FRANCESCHI S ET AL: "SOI technology for quantum information processing",2016 IEEE IEDM, 2016-12-03, DOI: 10.1109/IEDM.2016.7838409 divulgue un dispositif quantique à qubits de spin à points quantiques semi-conducteurs, dans lequel deux QD définis par des grilles sont couplés par effet tunnel, l'un servant à encoder un qubit et l'autre à la lecture. La lecture est réalisée par réflectométrie de porte RF au moyen d'un résonateur LC connecté à la grille du QD de lecture. Les technologies semi-conductrices sont étudiées pour la réalisation de qubits en raison de leur haut potentiel d'intégration, à l'image de l'électronique classique. Des électrons ou des trous sont individuellement confinés dans des puits quantiques se trouvant dans un cryostat à des températures cryogéniques (inférieures à 4 K, voire inférieures à 1 K) réalisés au sein de structures de confinement de tailles nanométriques définies de manière électrostatique et, dans le cas du silicium, d'architecture proche de celle des MOSFETs. L'application d'un champ magnétique statique (par exemple compris entre 100 mT et 1 T) permet de faire apparaître le spin des quasi-particules qui est un système quantique à deux niveaux mesurables, nommés « spin down » et « spin up ». Leur état quantique est une superposition de ces deux états représentés par la direction d'une flèche au sein d'une sphère, nommée sphère de Bloch. La manipulation (rotation) de ces spins est effectuée à l'aide d'une composante alternative du champ magnétique (de fréquence par exemple comprise entre 1 GHz et plusieurs dizaines de GHz) ou à l'aide d'un champ électrique alternatif aux mêmes fréquences dans le cas d'une interaction spin-orbite suffisante (cas des trous dans du silicium). La lecture des spins (up ou down) permet d'extraire une partie de l'information quantique selon sa probabilité d'être dans chaque état, déterminée par la superposition quantique.

La lecture d'un spin quantique utilise un processus de conversion spin vers charge électrique ou vers un mouvement de charge (capacité), suivi d'une détection de la charge électrique résultante. Plusieurs techniques de conversion existent, notamment par effet tunnel dépendant du spin (conversion spin vers charge) dans un réservoir, ou par effet tunnel dépendant du spin avec un autre puit (conversion spin vers mouvement de charge, équivalente à l'apparition d'une capacité variable suivant l'état du spin du qubit). La détection de la charge résultante se fait soit à l'aide d'un « Single-Electron Transistor » (SET) mesuré en courant ou par réflectométrie avec l'utilisation d'un résonateur LC. Lors d'une mesure par réflectométrie, une tension est appliquée sur un résonateur LC à sa fréquence de résonance. L'onde réfléchie par le résonateur LC est ensuite récupérée et démodulée afin d'en extraire le déphasage entre l'onde incidente et l'onde réfléchie, ce déphasage étant représentatif de la valeur de la capacité quantique, et donc de l'état du spin lu.

Actuellement, l'électronique de pointe utilisé pour la lecture (amplificateur à détection synchrone, générateurs de signaux, etc.) est placée à température ambiante (environ 300 K) et nécessite, pour chaque qubit, des câbles reliant cette électronique se trouvant à l'extérieur du cryostat (à température ambiante) aux qubits se trouvant à l'intérieur du cryostat. L'augmentation du nombre de ces lignes d'adressage avec le nombre de qubits entraîne des pertes par conduction qui limitent la température minimale de ces cryostats. En plus de ces éléments fonctionnant à température ambiante, des composants actifs (amplificateurs, filtres, etc.) et passifs (coupleurs, inductances, T de polarisation, etc.) sont placés dans des compartiments fonctionnant à différentes température (77 K, 4 K, <1K), encombrant significativement la place disponible au sein des cryostats.

L'intégration à basse température de l'électronique de lecture serait avantageuse pour réduire le nombre d'entrées et de sorties au sein du cryostat et augmenter les bandes passantes atteignables grâce à la proximité de l'électronique de lecture avec les qubits. Toutefois, les méthodes actuelles de lecture telle que la réflectométrie ne sont pas adaptées pour réaliser une telle intégration. En effet, l'utilisation de dispositifs supplémentaires (SETs ou réservoirs quantiques) réduit le nombre de qubits pouvant être intégrés par unité de surface et nécessite des interactions à plus longue portée entre plus proches voisins. L'utilisation de dispositifs supplémentaires (SET ou réservoirs quantiques) n'est donc pas envisageable à cause des interactions longue portée nécessaires entre plus proches qubits. D'un autre côté, la réflectométrie nécessite la propagation d'ondes électriques de fréquence égale à quelques centaines de MHz pour des trous (et jusqu'à des dizaines de GHz pour des électrons) qui implique l'utilisation de composants macroscopiques tels que des coupleurs directionnels et des inductances discrètes. Enfin, l'utilisation de composants macroscopiques autour de la matrice de qubits (dont les dimensions maximales sont généralement de 1 mm par 1 mm) génère des capacités parasites qui limitent la fréquence de résonnance et la sensibilité de la détection réalisée.

Le document « Gate-reflectometry dispersive readout and coherent control of a spin qubit in silicon » de A. Crippa et al., Nature Communications, vol.10, Article number: 2776 (2019), décrit une mesure par réflectométrie d'une capacité quantique associée aux spins de trous dans une structure en double puits quantiques sur silicium CMOS. Le point de polarisation continue en tension du qubit est appliqué à température ambiante et est superposé à une tension alternative à travers un T de polarisation fonctionnant à une température de 20 mK. Cette tension alternative de fréquence égale à 339 MHz est produite à température ambiante, passe par un coupleur directionnel fonctionnant également à 20 mK, et est réfléchie sur un résonateur LC constitué d'une inductance externe à la puce contenant les qubits et reliée en série à la capacité quantique dépendante de l'état de spin. Le signal réfléchi repasse par le coupleur directionnel et est amplifié à 4 K puis retourne à 300 K où le signal est démodulé à la fréquence incidente (339 MHz). La phase du signal démodulé est extraite afin d'avoir la variation de capacité due aux spins. La sensibilité est de 18 mrad/fF. Le spin peut être détecté en une seule mesure (« single-shot » en anglais) avec des temps d'intégration supérieurs à 100 ms.

Une telle lecture de qubit a pour avantages de ne pas faire appel à un dispositif additionnel pour réaliser la détection capacitive (la grille du qubit sert de capacité de détection) et d'avoir une sensibilité capacitive augmentée grâce au résonateur série LC utilisé. Toutefois, elle a pour inconvénients de faire appel à des composants discrets volumineux (coupleurs, T de polarisation, inductance CMS ou montée en surface, etc.), et d'avoir une sensibilité capacitive limitée par les capacités parasites importantes dues aux différentes connexions.

## EXPOSÉ DE L'INVENTION

Un but de la présente invention est de proposer un dispositif quantique à au moins un qubit de spin ne présentant pas les inconvénients de la lecture par réflectométrie et permettant une intégration à basse température (inférieure à 4 K) de l'électronique de lecture.

Pour cela, la présente invention propose un dispositif quantique à qubits de spin, comportant au moins :

- un qubit de donnée et un qubit de mesure réalisés dans une couche semi-conductrice et couplés l'un à l'autre par au moins une jonction tunnel, ou couplage tunnel, réalisée dans la couche semi-conductrice, chacun des qubits de donnée et de mesure comprenant au moins une boîte quantique et au moins une grille de commande électrostatique couplée à la boîte quantique ;
- une inductance couplée en parallèle ou en série à la grille du qubit de mesure ou à la grille du qubit de donnée ou à une autre grille couplée de manière capacitive à l'un des qubits de donnée ou de mesure, tel que l'inductance et une capacité formée par la grille à laquelle l'inductance est couplée forment un circuit LC ;
- une première borne d'entrée configurée pour recevoir une tension de commande périodique de fréquence $f_r$ sensiblement égale à la fréquence de résonance du circuit LC, $f_{LC}$, et qui est couplée au circuit LC ;
- un amplificateur de tension comprenant une entrée couplée à la grille à laquelle l'inductance est couplée ;
- une borne de sortie couplée à une sortie de l'amplificateur de tension.

Contrairement à une mesure par réflectométrie dans laquelle une onde de tension est envoyée puis l'onde de tension réfléchie sur la grille d'un qubit de mesure est mesurée, ce dispositif propose de faire appel à un circuit LC formé par une inductance et la grille d'au moins un qubit de mesure ou la grille d'au moins un qubit de donnée ou au moins une autre grille couplée de manière capacitive à l'un ou plusieurs des qubits de donnée ou de mesure, sur lequel est appliqué un signal d'excitation de fréquence égale à sa fréquence de résonance $f_{LC}$ et en sortie duquel une tension est mesurée. Une telle mesure correspond à une mesure d'impédance à partir de laquelle l'état quantique de spin du qubit de donnée est lu.

Ce dispositif quantique peut être réalisé avec des composants discrets fonctionnant à basse température (inférieure ou égale à 4K). Toutefois, ce dispositif quantique peut être avantageusement réalisé tel que les qubits de donnée et de mesure, l'inductance, l'amplificateur de tension, la première borne d'entrée et la borne de sortie soient réalisés sous la forme d'un circuit intégré apte à fonctionner à une température inférieure ou égale à 4K. Ainsi, ce circuit intégré, qui inclut les qubits et l'électronique de mesure, présente une forte densité d'intégration et peut être disposé dans un cryostat fonctionnant à des températures cryogénique (< 4K). Cela est possible du fait que ce dispositif quantique ne fait pas appel à des composants discrets volumineux tels que des coupleurs ou des T de polarisation. En outre, l'intégration de toute l'électronique de lecture (dont fait partie l'amplificateur de tension) et des qubits dans le même circuit intégré permet de limiter les longueurs des interconnexions, et donc les capacités parasites, entre les différents éléments du dispositif quantique et notamment ceux formant l'électronique de lecture, ce qui augmente la sensibilité capacitive du dispositif lors de la lecture des qubits.

En considérant le circuit LC comme un quadripôle, la mesure par réflectométrie réalisée dans l'art antérieur correspond à une mesure du paramètre S11, alors que dans le dispositif quantique de l'invention, le paramètre mesuré correspond au paramètre S12 ou Z11 ou Z12 ou Z22.

Le dispositif quantique peut être utilisé avec des spins de trous et/ou des spins d'électrons.

L'expression « une autre grille couplée de manière capacitive à l'un des qubits de donnée ou de mesure » peut désigner par exemple une grille formée à côté de la grille d'un des qubits de donnée ou de mesure et qui, de par sa proximité avec ce qubit, est couplé avec celui-ci.

La fréquence $f_r$ correspond à la fréquence de fonctionnement du circuit LC. Cette fréquence $f_r$ est « sensiblement égale » à la fréquence de résonance du circuit LC $f_{LC}$, c'est-à-dire a une valeur comprise entre la valeur de cette fréquence de résonance - $f_{LC}$/2Q MHz et la valeur de cette fréquence de résonance + $f_{LC}$/2Q MHz. La fréquence de résonance du circuit LC $f_{LC}$ est égale à $\dfrac{1}{2\pi\sqrt{L.C}}$. Cette variation possible de la fréquence de fonctionnement du circuit LC par rapport à la fréquence de résonance de ce circuit est due au fait que la résonance du résonateur à une largeur typique égale $f_{LC}$/Q, avec $Q = \left(\dfrac{L}{C}\right)^{\frac{1}{2}}/R$ correspondant au facteur de qualité du résonateur RLC au sein de laquelle la sensibilité reste intacte. Le terme R correspond physiquement aux pertes énergétiques de l'inductance, c'est-à-dire soit des pertes dans l'inductance passive (résistance du matériau, effet de peau, etc.), soit des pertes dans l'inductance active dues aux conductances des MOSFETs de l'inductance active (pertes résistives dans les transistors). Dans un fonctionnement autour de la fréquence de résonance, les deux types d'inductance (passive et active) peuvent être ramenées à un circuit équivalent RLC, avec le R correspondant à la résistance équivalente en série de l'inductance.

La grille, à laquelle l'inductance est couplée, peut être également couplée à l'entrée de l'amplificateur de tension par une connexion électrique ayant une longueur totale « l » telle que : l < c/(10.$f_r$). Du fait que le dispositif quantique réalise une mesure d'impédance à partir de laquelle l'état quantique de spin du qubit de donnée est lu, il n'est pas nécessaire d'avoir, entre l'amplificateur et la grille à laquelle l'inductance est couplée, d'avoir une longueur de connexion importante car il n'y a pas besoin de former des ondes de tensions, contrairement aux dispositifs de l'art antérieur réalisant une mesure par réflectométrie. La liaison entre la grille à laquelle l'inductance est couplée et l'entrée de l'amplificateur peut être vue comme une ligne équipotentielle.

Avec une telle longueur de connexion, l'inductance, l'amplificateur et le qubit de mesure sont très proches et aucune onde propagatrice n'est présente dans le système, conformément à l'approximation des régimes quasi stationnaires (ARQS) qui s'applique dans ce cas. Dans le dispositif, il n'est pas possible de définir un paramètre de réflexion puisqu'aucune onde ne se propage dans le système.

L'ARQS, qui permet de négliger les phénomènes propagatifs (approximation dans laquelle le dispositif quantique décrit ici se place, contrairement à ceux utilisant la réflectométrie), est valide lorsque la longueur de la connexion électrique entre la grille, à laquelle l'inductance est couplée, et l'entrée de l'amplificateur de tension est plus faible que la longueur d'onde $\lambda$ = c/$f_r$, avec c correspondant à la vitesse de la lumière dans le milieu considéré. Pour vraiment négliger les phénomènes propagatifs et accentuer la validité de l'ARQS, il est généralement considéré que la longueur d'onde à considérer pour le dimensionnement de la longueur de la connexion électrique est inférieure à c/(10.$f_r$). Cette longueur de connexion est par exemple égale à environ 10 cm, ou plus généralement comprise entre 3 cm et 30 cm pour $f_r$ comprise entre 1 GHz et 100 MHz.

Dans un dispositif quantique utilisant la réflectométrie, la taille du système formée par le qubit, le système résonant couplé au qubit et l'amplificateur est bien supérieure à la longueur d'onde $\lambda$. Dans le dispositif quantique décrit ici, la taille du système est bien inférieure à la longueur d'onde $\lambda$.

De manière avantageuse, l'inductance et/ou l'amplificateur de tension peuvent être réalisés dans la couche semi-conductrice.

L'inductance peut être couplée en parallèle à la grille du qubit de mesure ou à la grille du qubit de donnée ou à ladite autre grille couplée de manière capacitive à l'un des qubits de donnée ou de mesure, entre cette grille et un potentiel électrique de référence, et le dispositif quantique peut comporter en outre une source de courant commandée en tension et comprenant une entrée couplée à la première borne d'entrée et une sortie couplée au circuit LC. Le circuit LC formé par l'inductance et la grille du qubit de mesure correspond dans ce cas à un circuit LC parallèle qui permet de filtrer tous les signaux et bruits parasites éloignés de la fréquence de résonance du circuit LC. La sensibilité en phase d'un circuit LC parallèle est égale à Q/$C_p$, en rad/farads, avec Q le facteur de qualité qui est égal à $\left(\dfrac{L}{C_p}\right)^{\frac{1}{2}}/R$, et $C_p$ la capacité parasite

en parallèle de la capacité du qubit. L'intégration à basse température de l'électronique de lecture permet d'obtenir une meilleure maîtrise de la fréquence de travail ($C_p$ contrôlé), une meilleure sensibilité grâce à des capacités parasites $C_p$ réduites.

De plus, la source de courant permet dans ce cas de transformer la tension de commande reçue sur la première borne d'entrée en un courant de commande et d'envoyer ce courant de commande sur l'inductance, c'est-à-dire en entrée du circuit LC.

Lorsque les qubits de donnée et de mesure, l'inductance, l'amplificateur de tension, la première borne d'entrée et la borne de sortie sont réalisés sous la forme d'un circuit intégré apte à fonctionner à une température inférieure ou égale à 4K, la source de courant peut faire partie de ce circuit intégré.

La source de courant peut comporter des composants électroniques réalisés dans la même couche semi-conductrice que les qubits.

Selon un mode de réalisation avantageux, l'inductance peut correspondre à une inductance active, par exemple de type Karsilayan-Schaumann. Une telle inductance active, formée par des composants électroniques CMOS, a une taille réduite par rapport à une inductance passive de même valeur d'impédance (de l'ordre de 1 nH/25 $\mu m^2$ pour une inductance active, et de 1nH/mm$^2$ pour une inductance passive), ce qui autorise l'intégration de plusieurs de inductances dans le circuit intégré, par exemple une par ligne d'adressage afin d'effectuer des mesures par ligne en parallèle lorsque le dispositif quantique comporte une matrice de qubits. Une telle inductance active a également pour avantage de pouvoir être intégrée au plus près des qubits, ce qui permet de minimiser les capacités d'accès. Cette structure permet également de contrôler *in situ* les paramètres de l'inductance et donc d'avoir le choix entre un facteur de qualité élevé (ce qui se traduit par une sensibilité du dispositif) et un facteur de qualité faible (ce qui se traduit par une vitesse de mesure élevée). Un autre avantage apporté par l'utilisation d'une ou plusieurs inductances actives de type Karsilayan-Schaumann réalisée avec des transistors NMOS (hormis les transistors de polarisation qui peuvent être de type P) dans le dispositif quantique est sa faible consommation électrique tout en étant compatible avec des tensions de seuils de transistors augmentées à basses températures.

De manière avantageuse, l'inductance peut comporter des capacités variables contrôlant les valeurs de l'inductance et du facteur de qualité indépendamment l'une de l'autre. De telles capacités variables permettent de maîtriser et optimiser les compromis sensibilité-bruit et sensibilité-vitesse de lecture du dispositif quantique. En outre, le fait de pouvoir ajuster le facteur de qualité de l'inductance permet d'optimiser le compromis vitesse de lecture/précision de lecture.

La source de courant peut comporter au moins deux transistors de type MOSFET formant un miroir de courant et couplés à au moins un filtre RC. En variante, la source de courant peut être formée par d'autres éléments, comme par exemple un transistor piloté en tension via l'application de la superposition d'une tension continue et d'une tension alternative, ou un circuit RC.

En variante, l'inductance peut être couplée en série à la grille du qubit de mesure ou à la grille du qubit de donnée ou à ladite autre grille couplée de manière capacitive à l'un des qubits de donnée ou de mesure, entre cette grille et la première borne d'entrée.

Le dispositif quantique peut comporter en outre :

- un premier générateur de tension dont une sortie est couplée à la première borne d'entrée, et apte à délivrer sur sa sortie la tension de commande périodique de fréquence $f_r$ ;
- un premier démodulateur I-Q dont une entrée est couplée à la borne de sortie et apte à réaliser une démodulation du signal de sortie de l'amplificateur de tension à la fréquence $f_r$.

Selon une configuration avantageuse, le dispositif quantique peut comporter une matrice de qubits formée de plusieurs qubits de donnée et plusieurs qubits de mesure réalisés dans la couche semi-conductrice, chacun des qubits de donnée étant couplé à un des qubits de mesure par au moins une jonction tunnel réalisée dans la couche semi-conductrice.

Dans ce cas, les grilles des qubits de données appartenant à une même colonne de la matrice peuvent être reliées électriquement les unes aux autres et les grilles des qubits de mesure appartenant à une même ligne de la matrice peuvent être reliées électriquement les unes aux autres.

En présence d'une matrice de qubits, et dans la configuration du paragraphe ci-dessus, le dispositif quantique peut comporter en outre :

- un deuxième générateur de tensions comportant plusieurs sorties chacune couplée aux grilles de qubits de données appartenant à une seule et même colonne de la matrice, et apte à délivrer sur ses sorties des signaux de tension périodiques de fréquences $f_{m,i}$ différentes les unes des autres et inférieures à la fréquence $f_r$ ;
- un deuxième démodulateur I-Q dont une entrée est couplée à la sortie du premier démodulateur I-Q et apte à réaliser une démodulation du signal de sortie du premier démodulateur I-Q aux fréquences $f_{m,i}$.

Une telle architecture de lecture est compatible avec le multiplexage fréquentiel de qubits permettant la mesure simultanée d'une matrice de spins quantiques.

Le dispositif peut comporter plusieurs inductances chacune couplée en parallèle ou en série aux grilles des qubits de mesure appartenant à une seule et même ligne de la matrice ou à d'autres grilles couplées de manière capacitive auxdits qubits de mesure, tel que chacune des inductances et les grilles desdits qubits de mesure ou lesdites autres grilles d'une même ligne de la matrice forment un circuit LC.

Le dispositif quantique peut comporter le premier générateur de tension et le premier démodulateur I-Q, le premier générateur de tension et le premier démodulateur I-Q peuvent faire partie d'un premier circuit distinct du circuit intégré, et dans lequel, lorsque le dispositif quantique comporte le deuxième générateur de tensions et le deuxième démodulateur I-Q, le deuxième générateur de tensions et le deuxième démodulateur I-Q peuvent faire partie d'un deuxième circuit distinct du circuit intégré. Ainsi, les premier et deuxième générateurs de tension et les premier et deuxième démodulateur I-Q peuvent ne pas être intégré au circuit comportant la matrice de qubits et l'électronique de lecture, et peuvent fonctionner à une température non cryogénique (supérieure à 4K), par exemple à température ambiante.

Le dispositif quantique peut comporter en outre, lorsque les qubits de donnée et de mesure, l'inductance, l'amplificateur de tension, la première borne d'entrée et la borne de sortie sont réalisés sous la forme d'un circuit intégré, un cryostat configuré pour fournir un espace clos dans lequel la température est inférieure ou égale à 4K, le circuit intégré pouvant être disposé dans l'espace clos du cryostat.

Le dispositif quantique selon l'invention peut s'appliquer aux domaines suivants : calcul quantique, ingénierie quantique, système de mesure de capacité déporté (interfaces de capteurs capacitifs).

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un schéma de principe du fonctionnement du dispositif quantique, objet de la présente invention ;
- la figure 2 représente schématiquement un dispositif quantique, objet de la présente invention, selon un premier mode de réalisation ;
- la figure 3 représente schématiquement un dispositif quantique, objet de la présente invention, selon un deuxième mode de réalisation ;
- la figure 4 représente un exemple de réalisation du dispositif quantique, objet de la présente invention, selon le deuxième mode de réalisation ;
- la figure 5 représente une partie d'un dispositif quantique, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

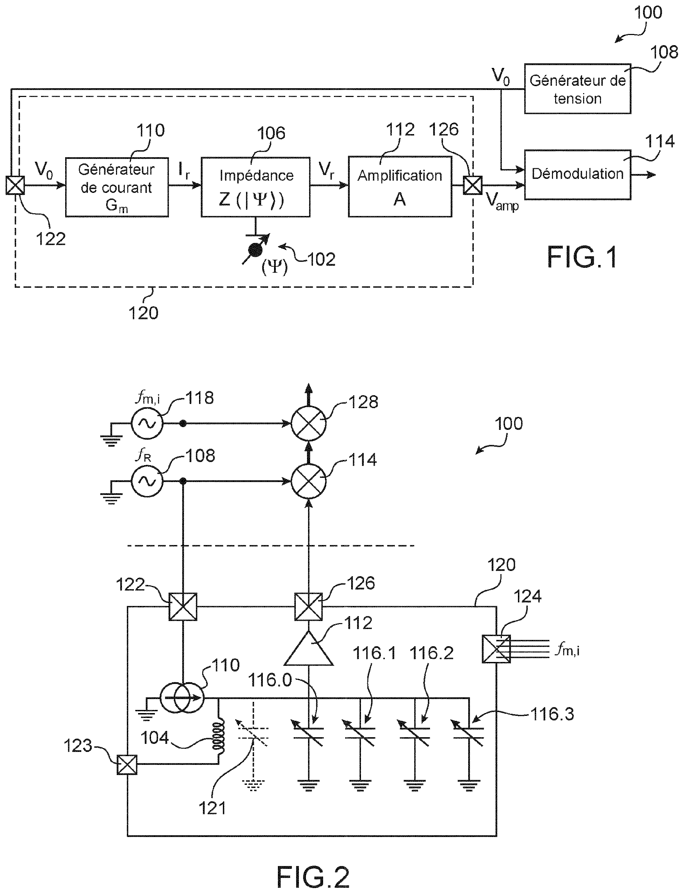

Le principe de fonctionnement d'un dispositif quantique 100 mettant en œuvre une nouvelle méthode de lecture, non couverte par les revendications, de l'état quantique de spin d'un qubit est décrit ci-dessous en lien avec la figure 1.

Le dispositif quantique 100 comporte au moins un qubit de donnée, non schématisé sur la figure 1, et au moins un qubit de mesure 102 via lequel la mesure de l'état quantique de spin du qubit de donnée est destinée à être réalisée. Les qubits de donnée et de mesure sont réalisés dans une couche semi-conductrice (non visible sur la figure 1) et sont couplés l'un à l'autre par au moins une jonction tunnel également réalisée dans la couche semi-conductrice. Chacun des qubits de donnée et de mesure comprend, ou est formé, par au moins une boîte quantique et au moins une grille de commande électrostatique couplée à la boîte quantique. Les qubits de donnée et de mesure correspondent à des puits quantiques destinés à fonctionner à une température cryogénique, c'est-à-dire inférieure ou égale à 4K. Sur la figure 1, l'état quantique du qubit de donnée à mesurer est noté |Ψ>. Les qubits de mesure et de donnée sont par exemple similaires à ceux décrits dans le document « Gate-reflectometry dispersive readout and coherent control of a spin qubit in silicon » de A. Crippa et al., Nature Communications, vol.10, Article number: 2776 (2019).

Le dispositif quantique 100 comporte également une inductance 104 (non visible sur la figure 1) couplée en parallèle ou en série à la grille d'un ou plusieurs qubits de mesure 102 telle que l'inductance 104 et la capacité formée par la ou les grilles du ou des qubits de mesure 102 forment un circuit LC. Par exemple, l'inductance 104 peut être couplée en parallèle au(x) qubit(s) de mesure 102, entre la ou les grilles du ou des qubits de mesure 102 et un potentiel électrique de référence. L'impédance de ce circuit LC est symbolisée sur la figure 1 et porte la référence 106. Cette impédance est notée $Z(|\Psi>)$ car sa valeur est fonction de la valeur de l'état quantique mesuré $|\Psi>$ du ou des qubits de donnée (la valeur de la capacité de la grille d'un qubit de mesure change si les deux spins des qubits de donnée et de mesure couplés l'un à l'autre par une jonction tunnel sont dans des états différents, et ne change pas si les deux spins des qubits de donnée et de mesure sont dans des états similaires). De manière avantageuse, l'inductance 104 est réalisée dans la même couche semi-conductrice que les qubits de données et de mesure. De plus, l'inductance 104 correspond avantageusement à une inductance active de type Karsilayan-Schaumann, et peut comporter des capacités variables contrôlant les valeurs de l'inductance et de son facteur de qualité indépendamment l'une de l'autre.

Le dispositif quantique 100 comporte également un premier générateur de tension 108 délivrant un signal de tension de commande périodique de fréquence $f_r$ sensiblement égale à la fréquence de résonance du circuit LC formé par l'inductance 104 et la capacité de la grille du qubit de mesure 102. Sur la figure 1, le signal de commande délivré par le premier générateur de tension 108 est noté $V_0$. Cette tension de commande $V_0$ est appliquée sur une première borne d'entrée 122 du dispositif 100.

La valeur de la fréquence de résonance du circuit LC dépend notamment du type de porteurs de charge dont le spin est utilisé pour former les qubits de données et de mesure. Par exemple, lorsque les qubits de donnée et de mesure se basent sur l'état quantique de spin de trous, la valeur de la fréquence de résonance du circuit LC peut être égale à plusieurs centaines de MHz, par exemple comprise entre 100 MHz et 1 GHz. Lorsque les qubits de donnée et de mesure se basent sur l'état quantique de spin d'électrons, la valeur de la fréquence de résonance du circuit LC peut être égale à plusieurs dizaines de GHz, par exemple comprise entre 10 GHz et 100 GHz.

En variante, le dispositif quantique 100 peut ne pas comporter le premier générateur de tension 108. Dans ce cas, le signal $V_0$ est produit à l'extérieur du dispositif quantique 100 qui comporte alors une entrée sur laquelle un signal analogue au signal $V_0$ est appliqué.

Lorsque l'inductance 104 est couplée en parallèle à la grille du qubit de mesure 102, le dispositif quantique 100 comporte également une source de courant 110 commandée en tension via une entrée de commande recevant le signal $V_0$ (via la première borne d'entrée 122). La source de courant 110 délivre en sortie un courant $I_r$ qui est également périodique de fréquence $f_r$. De manière avantageuse, la source de courant 110 est réalisée dans la même couche semi-conductrice que les qubits de donnée et de mesure. A titre d'exemple, la source de courant 110 peut comporter au moins deux transistors de type MOSFET formant un miroir de courant et couplés à au moins un filtre RC.

Le courant $I_r$ est appliqué en entrée du circuit LC afin que le circuit LC oscille à sa fréquence de résonance.

Contrairement aux méthodes de l'art antérieur dans lesquelles le signal réfléchi par un tel circuit LC est mesuré pour déterminer l'état quantique du qubit de donnée, on mesure ici une tension $V_r$ obtenue en sortie du circuit LC, ce qui correspond à une mesure d'impédance du circuit LC (compte tenu de l'injection du courant $I_r$ réalisée dans le circuit LC) afin d'en déduire le changement d'impédance dû à l'état quantique mesuré.

Le dispositif quantique 100 comporte en outre un amplificateur de tension 112 dont une entrée est couplée à la grille du qubit de mesure 102, amplifiant ainsi le signal $V_r$. Le signal délivré par l'amplificateur de tension 112 est appelé $V_{amp}$ et est délivré sur une borne de sortie 126. De manière avantageuse, l'amplificateur de tension 112 est réalisé dans la même couche semi-conductrice que les qubits de donnée et de mesure.

Les qubits de donnée et de mesure 102, l'inductance 104, la source de courant 110, l'amplificateur de tension 112, la première borne d'entrée 122 et la borne de sortie 126 sont réalisés sous la forme d'un circuit intégré 120 fonctionnant à une température cryogénique, c'est-à-dire inférieure ou égale à 4K. Sur la figure 1, le circuit intégré 120 est délimité symboliquement par des traits pointillés.

En outre, la grille du qubit de mesure 102 est couplée à l'entrée de l'amplificateur de tension 112 par une connexion électrique ayant une longueur totale « l » inférieure, voire très inférieure (d'au moins un facteur 10) au rapport $c/(10.f_r)$. La réalisation d'une telle connexion électrique est possible grâce à l'intégration de l'amplificateur de tension 112 avec les qubits de données et de mesure au sein d'un même circuit intégré 120 fonctionnant à une température cryogénique.

Le dispositif quantique 100 comporte en outre un premier démodulateur I-Q 114 qui, contrairement aux autres éléments précédemment décrits du dispositif quantique 100, ne fait pas partie du circuit intégré 120 fonctionnant à une température cryogénique mais est destiné à fonctionner à une température supérieure à 4K, par exemple à la température ambiante. Le premier démodulateur I-Q 114 reçoit en entrée les signaux $V_0$ et $V_{amp}$, et réalise une démodulation du signal $V_{amp}$ à la fréquence $f_r$ obtenue à partir du signal $V_0$, ce qui permet de déterminer la phase de l'impédance du circuit LC et d'en déduire la valeur de $|\Psi>$.

Le dispositif 100 propose donc de mesurer la phase de l'impédance du circuit LC stimulé à l'aide d'un courant périodique de fréquence sensiblement égale à la fréquence de résonance du circuit LC.

L'impédance Z du circuit LC peut s'exprimer par l'équation suivante :

$$Z = \frac{1}{1 + \dfrac{jQ\omega}{\omega_0} - \left(\dfrac{\omega}{\omega_0}\right)^2}$$

Avec Q correspondant au facteur de qualité du circuit LC, et $\omega_0$ correspondant à la fréquence de résonance $f_r$ du circuit LC.

La phase $\Phi_{Vr}$ de la tension $V_r$ obtenue en sortie de l'amplificateur 112 est telle que :

$$\phi_{Vr} = -\arctan\frac{Q\omega}{\omega_0} * \frac{1}{1 - \left(\dfrac{\omega}{\omega_0}\right)^2}$$

A la fréquence de résonance, c'est-à-dire pour $\omega = \omega_0$, et en considérant, par approximation linéaire, que la capacité C de la grille du qubit de mesure correspond à la somme de la capacité parasite $C_p$ couplée au circuit LC et de la variation $\delta C$ due à l'état quantique du spin du qubit de mesure, alors $\omega_0$ devient $\omega_0 + \delta\omega_0$ avec $\delta\omega_0 = -\frac{1}{2}\frac{\omega_0}{C}\delta C$.

En considérant $\delta C << C_p$, la variation de phase $\delta\Phi_{Vr}$ due à l'état quantique du spin du qubit de mesure est donc telle que :

$$\delta\phi_{Vr} \simeq -\arctan\frac{2Q}{\omega_0} * \delta\omega_0 \simeq \arctan Q\frac{\delta C}{C_p} \simeq Q\frac{\delta C}{C_p}$$

Dans le cas d'une forte sensibilité, avec $\delta C >> C_p$, la variation de phase est :

- s'il n'y a pas de capacité quantique : $\delta\Phi_{Vr} = 0$ ;
- s'il y a une capacité quantique : $\delta\Phi_{Vr} = +90°$ ou $-90°$.

Dans le dispositif quantique 100, l'intégration des qubits de donnée et de mesure 102, de l'inductance 104, de la source de courant 110, de l'amplificateur de tension 112, de la première borne d'entrée 122 et de la borne de sortie 126 dans un même circuit intégré 120 peut être réalisée de façon monolithique ou en faisant appel à un ou plusieurs interposeurs ou en réalisant un circuit intégré 3D. Une telle intégration de ces éléments dans un seul circuit intégré permet de minimiser les capacités parasites de connexion entre ces éléments, qui sont par exemple de l'ordre de quelques pF à quelques dizaines de fF, et donc d'augmenter la sensibilité de lecture du dispositif quantique 100. Les qubits du dispositif 100 sont compatibles avec les technologies CMOS.

Selon une variante, le dispositif 100 peut être tel que l'inductance 104 soit couplée, en série ou en parallèle, à la grille d'un qubit de donnée. Selon une autre variante, l'inductance 104 peut être couplée, en série ou en parallèle, à une autre grille couplée de manière capacitive à l'un des qubits de donnée ou de mesure.

Lorsque l'inductance 104 est couplée en série à la grille d'un qubit de mesure 102 ou d'un qubit de donnée ou à une autre grille couplée de manière capacitive à l'un des qubits de donnée ou de mesure, le dispositif 100 ne comporte pas la source de courant 110, la tension $V_0$ étant appliquée directement sur l'une des bornes de l'inductance 104 via la première borne d'entrée 122.

Le dispositif quantique 100 selon un premier mode de réalisation est décrit ci-dessous en lien avec la figure 2.

Dans ce premier mode de réalisation, le dispositif quantique 100 comporte une matrice de qubits formée de plusieurs qubits de donnée et plusieurs qubits de mesure réalisés dans la même couche semi-conductrice, chacun des qubits de donnée étant couplé à un des qubits de mesure par au moins une jonction tunnel réalisée également dans la couche semi-conductrice. Dans une configuration avantageuse de cette matrice, les grilles des qubits de données appartenant à une même colonne de la matrice sont reliées électriquement les unes aux autres et les grilles des qubits de mesure appartenant à une même ligne de la matrice sont reliées électriquement les unes aux autres.

Sur la figure 2, quatre capacités référencées 116.0, 116.1, 116.2 et 116.3 représentent les capacités des grilles de quatre qubits de mesure d'une même ligne de la matrice de qubits. Du fait que les grilles de ces quatre qubits de mesure sont reliées électriquement entre elles, les capacités formées par ces grilles sont reliées en parallèle les unes aux autres.

Afin de pouvoir distinguer entre elles les mesures simultanées réalisées pour des qubits de mesure disposés sur

**EP 3 839 837 B1**

une même ligne de la matrice, et donc dont les grilles sont reliées électriquement entre elles, des signaux périodiques de fréquences différentes sont appliqués sur les grilles des qubits de données associés à ces qubits de mesure. Pour cela, le dispositif quantique 100 comporte un deuxième générateur de tensions 118 comportant plusieurs sorties chacune couplée aux grilles de qubits de données appartenant à une seule et même colonne de la matrice. Ce deuxième générateur de tensions 118 est apte à délivrer sur ses sorties des signaux de tension périodiques de fréquences $f_{m,i}$ différentes les unes des autres et inférieures à la fréquence $f_r$, avec i égal au nombre de qubits de mesure présent sur chaque ligne de la matrice de qubits. Sur l'exemple représenté sur la figure 2, les grilles des quatre qubits de donnée couplés aux quatre qubits de mesure dont les capacités sont représentées reçoivent chacune un signal de tension périodique de fréquence $f_{m,0}$, $f_{m,1}$, $f_{m,2}$ ou $f_{m,3}$.

Sur l'exemple de la figure 2, la référence 120 désigne le circuit intégré sur lequel sont réalisés la matrice de qubits, l'inductance 104, la source de courant 110, l'amplificateur de tension 112, la première borne d'entrée 122 et le borne de sortie 126. Les capacités parasites de connexion entre ces éléments du circuit intégré 120 sont symbolisées par une capacité référencée 121, représentée en traits pointillés et couplée en parallèle aux capacités 116.0 - 116.3. Bien qu'une seule inductance 104 soit représentée, le dispositif quantique 100 comporte plusieurs inductances 104 telles qu'au moins une inductance 104 soit associée à chaque ligne de qubits.

Dans ce premier mode de réalisation, l'inductance 104 correspond à une inductance passive. L'inductance 104 comporte une de ses bornes couplée à une deuxième borne d'entrée 123 faisant partie du circuit intégré 120 et sur laquelle un potentiel continu est appliqué. Ce potentiel continu, qui se retrouve appliqué sur les grilles des qubits de mesure formant les capacités 116.0 - 116.3, permet de piéger un électron ou un trou au sein de chacun des puits quantiques de ces qubits.

La frontière entre les éléments du dispositif quantique 100 fonctionnant à une température cryogénique, inférieure à 4K et par exemple inférieure à 1K, et ceux fonctionnant à température ambiante, par exemple égale à 300K, est représentée symboliquement par un trait pointillé au-dessus du circuit intégré 120. Le circuit intégré 120 est destiné à fonctionner à une température cryogénique, tandis que les générateurs de tension 108 et 118 sont destinés à fonctionner à la température ambiante. Le circuit intégré 120 comporte la première borne d'entrée 122 sur laquelle le signal périodique de fréquence $f_r$ est envoyé depuis le premier générateur de tension 108, et une troisième borne d'entrée 124 sur laquelle les signaux périodiques de fréquences $f_{m,i}$ sont envoyés depuis le deuxième générateur de tension 118.

Ce dispositif quantique 100 réalise donc un multiplexage fréquentiel des signaux de réponse des qubits de mesure à des fréquences $f_{m,i}$ générées à température ambiante.

Dans ce premier mode de réalisation, en reprenant les équations précédemment écrites, la variation de capacité $\delta C$ pour chaque qubit peut s'écrire par l'équation :

$$\delta C = \Sigma_i C_{qu} \cos(f_{m,i} t)$$

En considérant $\delta C \ll C_p$, la variation de phase $\delta\phi_{Vr}$ de la tension $V_r$ correspond à :

$$\delta\phi_{Vr} \simeq \sum_i Q \frac{C_{qu}}{C_p} \cos(f_{m,i} t)$$

Le signal obtenu en sortie de l'amplificateur de tension 112 est délivré sur une sortie 126 du circuit intégré 120 et appliqué sur une entrée du premier démodulateur I-Q 114. La phase est extraite par démodulation synchrone à la fréquence $f_r$ par le premier démodulateur I-Q 114. Cette phase est constituée de plusieurs signaux aux fréquences de multiplexages $f_{m,i}$. Une seconde démodulation synchrone aux fréquences $f_{m,i}$ est réalisée par un deuxième démodulateur I-Q 128, ce qui permet d'extraire l'amplitude de chaque composante de la phase afin de remonter aux états de spin individuels des qubits lus.

En variante de ce premier mode de réalisation, le dispositif 100 peut être tel que l'inductance 104 soit couplée en parallèle à un nombre différent de grilles de qubits de mesure (au moins une grille d'un qubit de mesure). Selon une autre variante, l'inductance 104 peut être couplée en parallèle à la grille d'au moins un qubit de donnée. Selon une autre variante, l'inductance 104 peut être couplée en parallèle à une autre grille couplée de manière capacitive à au moins l'un des qubits de donnée ou de mesure.

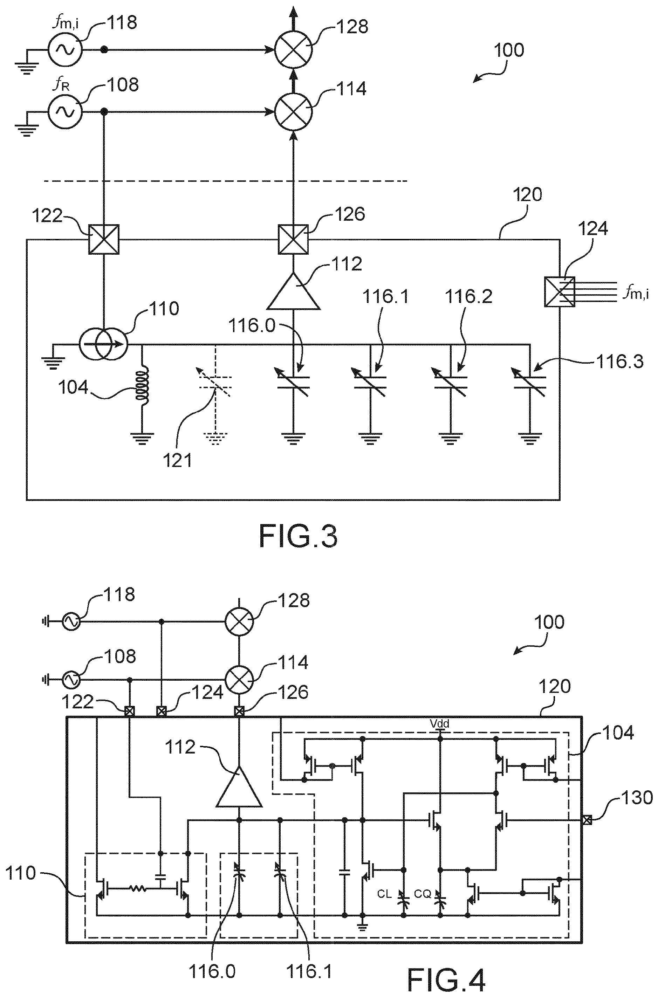

Le dispositif quantique 100 selon un deuxième mode de réalisation est décrit ci-dessous en lien avec la figure 3.

Par rapport au dispositif quantique 100 selon le premier mode de réalisation précédemment décrit en lien avec la figure 2 et dans lequel l'inductance 104 correspond à une inductance passive, l'inductance 104 du dispositif quantique selon le deuxième mode de réalisation correspond à une inductance active. Cette inductance active est formée à partir de transistors MOSFET et de capacités. De manière avantageuse, l'inductance 104 correspond à une inductance active de type Karsilayan-Schaumann. Sur l'exemple représenté sur la figure 3, l'inductance 104 comporte une première borne couplée aux grilles des qubits de mesure formant les capacités 116.0 - 116.3, et une deuxième borne couplée à la masse.

L'inductance 104 est donc couplée en parallèle aux grilles des qubits de mesure qui forment ensemble un circuit LC parallèle.

Avec une telle inductance active, le potentiel électrique continu appliqué sur les grilles des qubits de mesure permettant de piéger un électron ou un trou au sein des puits quantiques formés par ces qubits se fait grâce au mode commun $V_{cm}$ de l'inductance 104.

La figure 4 représente un exemple de réalisation du dispositif quantique 100 selon le deuxième mode de réalisation.

Dans cet exemple de réalisation, l'inductance active 104 est de type Karsilayan-Schaumann. Cette inductance active 104 comporte plusieurs transistors MOSFET. Hormis ceux servant à former deux miroirs de courant, les autres transistors de l'inductance active 104 sont de type NMOS afin de bénéficier d'une meilleure mobilité des électrons et des tensions de seuils moins élevés que les PMOS à basses températures. Des transistors PMOS peuvent toutefois être utilisés afin de réduire le bruit généré par ces transistors.

L'inductance active 104 comporte également deux capacités variables, nommées $C_L$ et $C_Q$ sur la figure 4. La valeur de l'inductance 104 est reliée à celle de la capacité $C_L$, et le facteur de qualité de l'inductance 104 peut être ajusté grâce à la capacité $C_Q$. Les capacités variables $C_L$ et $C_Q$ permettent de contrôler indépendamment la valeur de l'inductance 104 et le facteur de qualité de l'inductance 104. Les capacités $C_L$ et $C_Q$ peuvent être formées par des banques de capacités contrôlées à l'aide d'un décodeur. L'inductance active 104 comporte une première borne d'entrée 130 sur laquelle un potentiel électrique continu est appliqué afin de commander le point de polarisation DC de la ligne des qubits associés à cette inductance 104 (seuls deux qubits formant deux capacités 116.0 et 116.1 sont représentés sur la figure 4).

L'inductance active 104 est équivalente à un circuit RLC. La valeur de sa fréquence de résonance peut être modifiée à l'aide de $C_L$ de ± 10 % et son facteur de qualité peut être contrôlé de l'ordre de l'unité à quelques centaines. La résistance équivalente de ce circuit RLC peut même être rendue négative afin de compenser d'éventuelles pertes lors de la connexion à la ligne de qubits (résistance d'accès, ...).

D'autres détails de réalisation d'une telle inductance active 104 sont décrits dans le document de H. Xiao et al., « A 5.4-GHz high-Q tunable active-inductor bandpass filter in standard digital CMOS technology », Analog Integrated Circuits and Signal Processing, avril 2007, vol.51, Issue 1, pp 1-9.

La source de courant 110 comporte un miroir de courant formé ici par deux transistors NMOS et couplé à un filtre RC fixant le point de polarisation continue DC et la modulation du courant envoyé sur les grilles des qubits de mesure. La valeur de la tension de polarisation continue DC est par exemple réglée afin de prélever un courant égal à environ 1 µA sur la source d'entrée de l'inductance active 104 et de régler la valeur de sa transconductance. Dans ce cas, la tension alternative de fréquence $f_r$ reçue par la source de courant 110 permet de générer une composante alternative de 100 nA qui se transforme en une amplitude en tension de 100 µV (valeur typique de la perturbation alternative permise tout en gardant les électrons/trous localisés au sein des puits quantiques des qubits) sur la grille des qubits ($|Z_{max}| = QL^{1/2}/C^{1/2}$).

Les grilles des qubits de mesure d'une même ligne sont reliées à l'entrée de l'inductance active 104. Lors de la lecture, la phase entre le signal entrant de fréquence $f_r$ et le signal sortant est mesuré par une démodulation synchrone, comme précédemment décrit

Lorsque les qubits sont disposés en matrice comme précédemment décrit, un multiplexage de qubits est réalisé. Les grilles des qubits de mesure d'une même ligne de la matrice sont toutes reliées à l'entrée de l'inductance active 104. Le point de polarisation DC de la ligne des qubits est imposé par la tension continue obtenue depuis l'inductance 104. Lors de la lecture, les qubits sont équivalents à des capacités variables dans le temps à des fréquences de multiplexage $f_{m,i} \ll f_r$ (avec par exemple $f_{m,i} < 0,1\, f_r$). Comme la capacité formée par les qubits est très faible face aux autres capacités (capacité d'entrée de l'inductance 104, interconnexions, ...), la modulation de capacité quantique revient à perturber linéairement la fréquence de résonance de l'inductance 104, entrainant une modulation linéaire de la phase du signal porté à la fréquence de résonance $f_r$ à ces fréquences de multiplexage $f_{m,i}$. Une démodulation est faite à la fréquence de résonance $f_r$ afin d'extraire la phase variant dans le temps selon les fréquences de multiplexage $f_{m,i}$.

La démodulation en fréquences est ainsi faite afin d'extraire l'amplitude des modulations aux fréquences $f_{m,i}$. L'état quantique de chaque qubit est alors déterminé suivant l'amplitude de la modulation de la phase aux fréquences $f_{m,i}$.

Les différentes variantes précédemment décrites pour le premier mode de réalisation peuvent s'appliquer également à ce deuxième mode de réalisation.

De manière avantageuse, dans tous les modes de réalisation, le dispositif quantique 100 comporte un nombre d'inductances 104 égal au nombre de lignes de la matrice de qubits. Chaque inductance 104 peut être intégrée à une extrémité d'une des lignes de qubits et couplée aux grilles des qubits de mesure de cette ligne de la matrice de qubits.

Dans les modes et exemples de réalisation précédemment décrits, le circuit LC du dispositif quantique 100 correspond à un circuit LC parallèle dans lequel l'inductance 104 est couplée en parallèle aux capacités formées par les grilles des qubits de mesure.

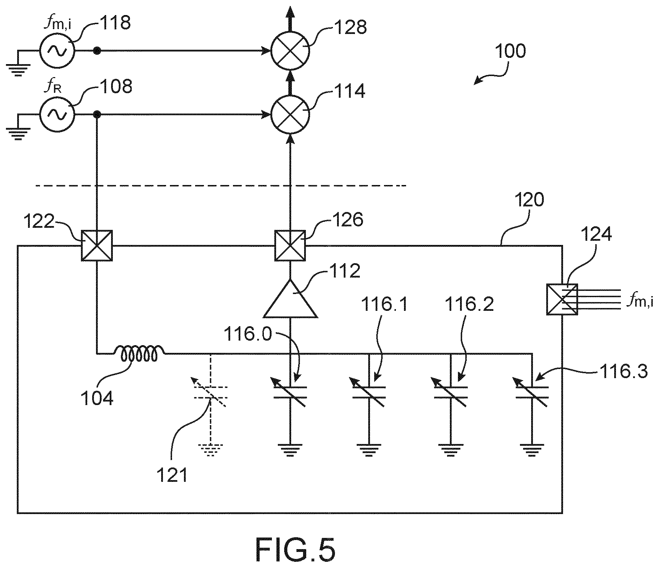

Dans un troisième mode de réalisation, il est possible que le circuit LC du dispositif quantique 100 corresponde à un circuit LC série dans lequel l'inductance 104 est couplée en série aux capacités formées par les grilles des qubits de mesure. Une telle configuration est schématisée sur la figure 5 qui représente un exemple de réalisation **du** dispositif 100 dans lequel l'inductance 104 forme, avec les capacités 116 formée par les grilles de plusieurs qubits de mesure, un circuit LC série. Dans ce troisième mode de réalisation, l'inductance 104 comporte une première de ses électrodes couplée à la première borne d'entrée 122 sur laquelle le signal de tension de fréquence $f_R$ est appliqué, et une deuxième de ses électrodes couplée aux grilles des qubits de mesure formant les capacités 116.

Dans ce troisième mode de réalisation, l'inductance 104 est avantageusement réalisée sous la forme d'une inductance active différentielle, dont un exemple de réalisation est décrit dans le document « A New Method for Performance Control of a Differential Active Inductor for Low Power 2.4GHz applications » de F. Belmas et al., 2010 IEEE International Conference on Integrated Circuit Design and Technology, 2-4 juin 2010, et dans le document « Design of Wide-tuning High-Q Differential Active Inductor For Multistandard Applications » de A.B. Ammadi, 2015 IEEE 12th International Multi-Conference on Systems, Signals & Devices (SSD15), 16-19 mars 2015.

Les différentes variantes précédemment décrites pour les premier et deuxième modes de réalisation peuvent s'appliquer à ce troisième mode de réalisation. Par exemple, l'inductance 104 peut être couplée en série à un nombre différent de grilles de qubits de mesure (au moins une grille d'un qubit de mesure), ou à une ou plusieurs grilles d'au moins un qubit de donnée ou à une ou plusieurs autres grilles couplées de manière capacitive à au moins l'un des qubits de donnée ou de mesure.

Pour tous les modes, variantes et exemples de réalisation précédemment décrits, bien que non représenté sur les différentes figures, le dispositif quantique 100 peut inclure un cryostat formant un espace clos dans lequel le circuit intégré 120 est disposé afin de fonctionner à une température inférieure ou égale à environ 4 K.

## Revendications

1. Dispositif quantique (100) à qubits de spin, comportant au moins :

   - un qubit de donnée et un qubit de mesure (102) réalisés dans une couche semi-conductrice et couplés l'un à l'autre par au moins une jonction tunnel réalisée dans la couche semi-conductrice, chacun des qubits de donnée et de mesure (102) comprenant au moins une boîte quantique et au moins une grille de commande électrostatique couplée à la boîte quantique ;
   - une inductance (104) couplée en parallèle ou en série à la grille du qubit de mesure (102) ou à la grille du qubit de donnée ou à une autre grille couplée de manière capacitive à l'un des qubits de donnée ou de mesure (102), tel que l'inductance (104) et une capacité formée par la grille à laquelle l'inductance (104) est couplée forment un circuit LC ;
   - une première borne d'entrée (122) configurée pour recevoir une tension de commande périodique de fréquence $f_r$ sensiblement égale à la fréquence de résonance du circuit LC et qui est couplée au circuit LC;
   - un amplificateur de tension (112) comprenant une entrée couplée à la grille à laquelle l'inductance (104) est couplée ;
   - une borne de sortie (126) couplée à une sortie de l'amplificateur de tension (112).

2. Dispositif quantique (100) selon la revendication 1, dans lequel les qubits de donnée et de mesure (102), l'inductance (104), l'amplificateur de tension (112), la première borne d'entrée (122) et la borne de sortie (126) sont réalisés sous la forme d'un circuit intégré (120) apte à fonctionner à une température inférieure ou égale à 4K.

3. Dispositif quantique (100) selon l'une des revendications précédentes, dans lequel la grille, à laquelle l'inductance (104) est couplée, est également couplée à l'entrée de l'amplificateur de tension (112) par une connexion électrique ayant une longueur totale « l » telle que $l < c/(10*f_r)$.

4. Dispositif quantique (100) selon l'une des revendications précédentes, dans lequel l'inductance (104) et/ou l'amplificateur de tension (112) sont réalisés dans la couche semi-conductrice.

5. Dispositif quantique (100) selon l'une des revendications précédentes, dans lequel l'inductance (104) est couplée en parallèle à la grille du qubit de mesure (102) ou à la grille du qubit de donnée ou à ladite autre grille couplée de manière capacitive à l'un des qubits de donnée ou de mesure (102), entre cette grille et un potentiel électrique de référence, et comportant en outre une source de courant (110) commandée en tension comprenant une entrée couplée à la première borne d'entrée et une sortie couplée au circuit LC.

6. Dispositif quantique (100) selon la revendication 5, dans lequel l'inductance (104) correspond à une inductance active de type Karsilayan-Schaumann.

**7.** Dispositif quantique (100) selon la revendication 6, dans lequel l'inductance (104) comporte des capacités variables ($C_L$, $C_Q$) contrôlant les valeurs de l'inductance (104) et du facteur de qualité indépendamment l'une de l'autre.

**8.** Dispositif quantique (100) selon l'une des revendications 5 à 7, dans lequel la source de courant (110) comporte au moins deux transistors de type MOSFET formant un miroir de courant et couplés à au moins un filtre RC.

**9.** Dispositif quantique (100) selon l'une des revendications 1 à 4, dans lequel l'inductance (104) est couplée en série à la grille du qubit de mesure (102) ou à la grille du qubit de donnée ou à ladite autre grille couplée de manière capacitive à l'un des qubits de donnée ou de mesure, entre cette grille et la première borne d'entrée (122).

**10.** Dispositif quantique (100) selon l'une des revendications précédentes, comportant en outre :

- un premier générateur de tension (108) dont une sortie est couplée à la première borne d'entrée (122), et apte à délivrer sur sa sortie la tension de commande périodique de fréquence $f_r$ ;
- un premier démodulateur I-Q (114) dont une entrée est couplée à la borne de sortie (126) et apte à réaliser une démodulation du signal de sortie de l'amplificateur de tension (112) à la fréquence $f_r$.

**11.** Dispositif quantique (100) selon l'une des revendications précédentes, comportant une matrice de qubits formée de plusieurs qubits de donnée et plusieurs qubits de mesure (102) réalisés dans la couche semi-conductrice, chacun des qubits de donnée étant couplé à un des qubits de mesure (102) par au moins une jonction tunnel réalisée dans la couche semi-conductrice.

**12.** Dispositif quantique (100) selon la revendication 11, dans lequel les grilles des qubits de données appartenant à une même colonne de la matrice sont reliées électriquement les unes aux autres et les grilles des qubits de mesure (102) appartenant à une même ligne de la matrice sont reliées électriquement les unes aux autres.

**13.** Dispositif quantique (100) selon les revendications 10 et 12, comportant en outre :

- un deuxième générateur de tensions (118) comportant plusieurs sorties chacune couplée aux grilles de qubits de données appartenant à une seule et même colonne de la matrice, et apte à délivrer sur ses sorties des signaux de tension périodiques de fréquences $f_{m,i}$ différentes les unes des autres et inférieures à la fréquence $f_r$ ;
- un deuxième démodulateur I-Q (128) dont une entrée est couplée à la sortie du premier démodulateur I-Q (114) et apte à réaliser une démodulation du signal de sortie du premier démodulateur I-Q (114) aux fréquences $f_{m,i}$.

**14.** Dispositif quantique (100) selon l'une des revendications 12 ou 13, comportant plusieurs inductances (104) chacune couplée en parallèle ou en série aux grilles des qubits de mesure (102) appartenant à une seule et même ligne de la matrice ou à d'autres grilles couplées de manière capacitive auxdits qubits de mesure (102), tel que chacune des inductances (104) et les grilles desdits qubits de mesure (102) ou lesdites autres grilles d'une même ligne de la matrice forment un circuit LC.

**15.** Dispositif quantique (100) selon la revendication 2 et l'une des revendications 10 à 14 dans lequel, lorsque le dispositif quantique (100) comporte le premier générateur de tension (108) et le premier démodulateur I-Q (114), le premier générateur de tension (108) et le premier démodulateur I-Q (114) font partie d'un premier circuit distinct du circuit intégré (120), et dans lequel, lorsque le dispositif quantique (100) comporte le deuxième générateur de tensions (118) et le deuxième démodulateur I-Q (128), le deuxième générateur de tensions (118) et le deuxième démodulateur I-Q (128) font partie d'un deuxième circuit distinct du circuit intégré (120).

**16.** Dispositif quantique (100) selon l'une des revendications précédentes, comportant en outre, lorsque les qubits de donnée et de mesure (102), l'inductance (104), l'amplificateur de tension (112), la première borne d'entrée (122) et la borne de sortie (126) sont réalisés sous la forme d'un circuit intégré (120), un cryostat configuré pour fournir un espace clos dans lequel la température est inférieure ou égale à 4K, le circuit intégré (120) étant disposé dans l'espace clos du cryostat.

**Patentansprüche**

**1.** Quantenvorrichtung (100) mit Spin-Qubits, die mindestens aufweist:

- ein Daten-Qubit und ein Mess-Qubit (102), die in einer Halbleiterschicht ausgeführt sind und durch mindestens einen in der Halbleiterschicht ausgeführten Tunnelanschluss miteinander gekoppelt sind, wobei jedes der Daten- und MessQubits (102) mindestens eine Quantenbox und mindestens ein mit der Quantenbox gekoppeltes elektrostatisches Steuergitter umfasst;

- eine Induktivität (104), die parallel oder in Reihe mit dem Gitter des MessQubits (102) oder dem Gitter des Daten-Qubits oder einem anderen Gitter gekoppelt ist, das kapazitiv mit einem der Daten- oder Mess-Qubits (102) gekoppelt ist, so dass die Induktivität (104) und eine Kapazität, die durch das Gitter gebildet wird, mit dem die Induktivität (104) gekoppelt ist, eine LC-Schaltung bilden;

- eine erste Eingangsklemme (122), die so konfiguriert ist, dass sie eine periodische Steuerspannung mit der Frequenz f empfängt, die im Wesentlichen der Resonanzfrequenz der LC-Schaltung entspricht und mit der LC-Schaltung gekoppelt ist;

- einen Spannungsverstärker (112), der einen Eingang umfasst, der mit dem Gitter gekoppelt ist, mit dem die Induktivität (104) gekoppelt ist;

- eine Ausgangsklemme (126), die mit einem Ausgang des Spannungsverstärkers (112) gekoppelt ist.

2. Quantenvorrichtung (100) nach Anspruch 1, wobei die Daten- und MessQubits (102), die Induktivität (104), der Spannungsverstärker (112), die erste Eingangsklemme (122) und die Ausgangsklemme (126) in Form einer integrierten Schaltung (120) ausgeführt sind, die geeignet ist, bei einer Temperatur von unter oder gleich 4 K zu arbeiten.

3. Quantenvorrichtung (100) nach einem der vorhergehenden Ansprüche, wobei das Gitter, mit dem die Induktivität (104) gekoppelt ist, ebenfalls mit dem Eingang des Spannungsverstärkers (112) durch eine elektrische Verbindung mit einer Gesamtlänge "l", wobei l < c/(10*$f_r$), gekoppelt ist.

4. Quantenvorrichtung (100) nach einem der vorhergehenden Ansprüche, wobei die Induktivität (104) und/oder der Spannungsverstärker (112) in der Halbleiterschicht ausgeführt sind.

5. Quantenvorrichtung (100) nach einem der vorhergehenden Ansprüche, wobei die Induktivität (104) parallel mit dem Gitter des Mess-Qubits (102) oder dem Gitter des Daten-Qubits oder mit dem anderen Gitter, das kapazitiv entweder mit dem Daten- oder dem Mess-Qubit (102) gekoppelt ist, zwischen diesem Gitter und einem elektrischen Referenzpotenzial gekoppelt ist und ferner eine spannungsgesteuerte Stromquelle (110) aufweist, die einen Eingang, der mit der ersten Eingangsklemme gekoppelt ist, und einen Ausgang, der mit der LC-Schaltung gekoppelt ist, umfasst.

6. Quantenvorrichtung (100) nach Anspruch 5, wobei die Induktivität (104) einer aktiven Karsilayan-Schaumann-Induktivität entspricht.

7. Quantenvorrichtung (100) nach Anspruch 6, wobei die Induktivität (104) variable Kapazitäten ($C_L$, $C_Q$) aufweist, die die Werte der Induktivität (104) und des Qualitätsfaktors unabhängig voneinander steuern.

8. Quantenvorrichtung (100) nach einem der Ansprüche 5 bis 7, wobei die Stromquelle (110) mindestens zwei stromspiegelbildende Transistoren des Typs MOSFET aufweist, die mit mindestens einem RC-Filter gekoppelt sind.

9. Quantenvorrichtung (100) nach einem der Ansprüche 1 bis 4, wobei die Induktivität (104) zwischen diesem Gitter und der ersten Eingangsklemme (122) in Reihe mit dem Gitter des Mess-Qubits (102) oder mit dem Gitter des Daten-Qubits oder mit dem anderen Gitter gekoppelt ist, das kapazitiv mit entweder dem Daten- oder dem Mess-Qubits gekoppelt ist.

10. Quantenvorrichtung (100) nach einem der vorhergehenden Ansprüche, die ferner aufweist:

- einen ersten Spannungsgenerator (108), von dem ein Ausgang mit der ersten Eingangsklemme (122) gekoppelt ist und der geeignet ist, über seinen Ausgang die periodische Steuerspannung mit der Frequenz $f_r$ bereitzustellen;

- einen ersten Demodulator I-Q (114), von dem ein Eingang mit der Ausgangsklemme (126) gekoppelt ist und der geeignet ist, eine Demodulation des Ausgangssignals des Spannungsverstärkers (112) bei der Frequenz $f_r$ auszuführen.

11. Quantenvorrichtung (100) nach einem der vorhergehenden Ansprüche, die eine Qubit-Matrix aufweist, die aus mehreren Daten-Qubits und mehreren Mess-Qubits (102) gebildet ist, die in der Halbleiterschicht ausgeführt sind, wobei jedes der Daten-Qubits mit einem der Mess-Qubits (102) durch mindestens einen in der Halbleiterschicht ausgeführten Tunnelanschluss gekoppelt ist.

12. Quantenvorrichtung (100) nach Anspruch 11, wobei die Gitter der Daten-Qubits, die zu einer gleichen Spalte der Matrix gehören, elektrisch miteinander verbunden sind und die Gitter der Mess-Qubits (102), die zu einer gleichen Zeile der Matrix gehören, elektrisch miteinander verbunden sind.

13. Quantenvorrichtung (100) nach den Ansprüchen 10 und 12, die ferner aufweist:

    - einen zweiten Spannungsgenerator (118), der mehrere Ausgänge aufweist, die jeweils mit den Daten-Qubit-Gittern gekoppelt sind, die zu einer einzigen und gleichen Spalte der Matrix gehören, und geeignet ist, über seine Ausgänge periodische Spannungssignale mit den Frequenzen $f_{m,i}$ bereitzustellen, die voneinander unterschiedlich und niedriger als die Frequenz $f_r$ sind;
    - einen zweiten Demodulator I-Q (128), von dem ein Eingang mit dem Ausgang des ersten Demodulators I-Q (114) gekoppelt ist und der geeignet ist, eine Demodulation des Ausgangssignals des ersten Demodulators I-Q (114) bei den Frequenzen $f_{m,i}$ auszuführen.

14. Quantenvorrichtung (100) nach einem der Ansprüche 12 oder 13, die mehrere Induktivitäten (104) aufweist, die jeweils parallel oder in Reihe mit den Gittern der Mess-Qubits (102) gekoppelt sind, die zu einer einzigen und gleichen Zeile der Matrix gehören, oder mit anderen Gittern, die kapazitiv mit den MessQubits (102) gekoppelt sind, so dass jede der Induktivitäten (104) und die Gitter der Mess-Qubits (102) oder die anderen Gitter einer gleichen Zeile der Matrix eine LC-Schaltung bilden.

15. Quantenvorrichtung (100) nach Anspruch 2 und einem der Ansprüche 10 bis 14, wobei, wenn die Quantenvorrichtung (100) den ersten Spannungsgenerator (108) und den ersten I-Q-Demodulator (114) aufweist, der erste Spannungsgenerator (108) und der erste I-Q-Demodulator (114) Teil einer ersten, von der integrierten Schaltung (120) verschiedenen Schaltung sind, und wobei, wenn die Quantenvorrichtung (100) den zweiten Spannungsgenerator (118) und den zweiten I-Q-Demodulator (128) aufweist, der zweite Spannungsgenerator (118) und der zweite I-Q-Demodulator (128) Teil einer zweiten, von der integrierten Schaltung (120) verschiedenen Schaltung sind.

16. Quantenvorrichtung (100) nach einem der vorhergehenden Ansprüche, die ferner, wenn die Daten- und Messqubits (102), die Induktivität (104), der Spannungsverstärker (112), die erste Eingangsklemme (122) und die Ausgangsklemme (126) in Form einer integrierten Schaltung (120) ausgebildet sind, ein Kryostat aufweist, das so konfiguriert ist, dass es einen geschlossenen Raum bereitstellt, in dem die Temperatur kleiner oder gleich 4 K ist, wobei die integrierte Schaltung (120) in dem geschlossenen Raum des Kryostats angeordnet ist.


**Claims**

1. A spin qubit quantum device (100) including at least:

    - a data qubit and a measurement qubit (102) made in a semiconducting layer and coupled to each other by at least one tunnel junction made in the semiconducting layer, each data and measurement qubit (102) comprising at least one quantum dot and at least one electrostatic control gate coupled to the quantum dot;
    - an inductor (104) coupled in parallel or series to the gate of the measurement qubit (102) or to the gate of the data qubit or to another gate capacitively coupled to one of the data or measurement qubits (102) such that the inductor (104) and a capacitor formed by the gate to which the inductor (104) is coupled form an LC circuit;
    - a first input terminal (122) configured to receive a periodic control voltage of frequency $f_r$ substantially equal to the resonant frequency of the LC circuit, and which is coupled to the LC circuit;
    - a voltage amplifier (112) comprising an input coupled to the gate to which the inductor (104) is coupled;
    - an output terminal (126) coupled to an output of the voltage amplifier.

2. The quantum device (100) according to claim 1, wherein the data and measurement (102) qubits, the inductor (104), the voltage amplifier (112), the first input terminal (122), and the output terminal (126) are made in the form of an integrated circuit (120) capable of operating at a temperature equal to or less than 4 K.

3. The quantum device (100) according to any of the preceding claims, wherein the gate to which the inductor (104) is coupled is also coupled to the input of the voltage amplifier (112) by an electrical connection having a total length "l" such that $l < c/(10\ f_r)$.

4. The quantum device (100) according to any of the preceding claims, wherein the inductor (104) and/or the voltage amplifier (112) are made in the semiconducting layer.

5. The quantum device (100) according to any of the preceding claims, wherein the inductor (104) is coupled in parallel to the gate of the measurement qubit (102) or to the gate of the data qubit or to said other gate capacitively coupled to one of the data or measurement (102) qubits, between said gate and a reference electric potential, and further including a voltage-controlled current source (110) comprising an input coupled to the first input terminal and an output coupled to the LC circuit.

6. The quantum device (100) according to claim 5, wherein the inductor (104) is a Karsilayan-Schaumann active inductor.

7. The quantum device (100) according to claim 6, wherein the inductor (104) includes variable capacitors ($C_L$, $C_Q$) controlling the values of the inductor (104) and the quality factor independently of each other.

8. The quantum device (100) according to any one of the claims 5 to 7, wherein the current source (110) includes at least two MOSFET transistors forming a current mirror and coupled to at least one RC filter.

9. The quantum device (100) according to any one of the claims 1 to 4, wherein the inductor (104) is coupled in series to the gate of the measurement qubit (102) or to the gate of the data qubit or to said other gate capacitively coupled to one of the data or measurement qubits, between this gate and the first input terminal (122).

10. The quantum device (100) according to any one of the preceding claims, further including:

   - a first voltage generator (108) of which one output is coupled to the first input terminal (122) and which is capable of outputting the periodic control voltage of frequency $f_r$ to the output thereof;
   - a first I/Q demodulator (114) of which one input is coupled to the output terminal (126) and which is capable of demodulating the output signal of the voltage amplifier (112) at the frequency $f_r$.

11. The quantum device (100) according to any one of the preceding claims, including a qubit matrix comprising a plurality of data qubits and a plurality of measurement qubits (102) made in the semiconducting layer, each data qubit being coupled to one of the measurement qubits (102) by at least one tunnel junction made in the semiconducting layer.

12. The quantum device (100) according to claim 11, wherein the gates of the data qubits belonging to the same column in the matrix are coupled electrically to each other, and the gates of the measurement qubits (102) belonging to the same row in the matrix are coupled electrically to each other.

13. The quantum device (100) according to claims 10 and 12, further including:

   - a second voltage generator (118) including a plurality of outputs, each coupled to the gates of data qubits belonging to the same column in the matrix, and capable of outputting to the outputs thereof periodic voltage signals of frequency $f_{m,i}$ which are different from each other and less than the frequency $f_r$;
   - a second I/Q demodulator (128), one input of which is coupled to the output of the first I/Q demodulator (114) and which is capable of demodulating the output signal of the first I/Q demodulator (114) at the frequencies $f_{m,i}$.

14. The quantum device (100) according to claim 12 or 13, including a plurality of inductors (104), each coupled in parallel or in series to the gates of the measurement qubits (102) belonging to the same row in the matrix or to other gates capacitively coupled to said measurement qubits (102), such that each inductor (104) and the gates of said measurement qubits (102) or said other gates in the same row of the matrix form an LC circuit.

15. The quantum device (100) according to claim 2 and any one of the claims 10 to 14, wherein, when the quantum device (100) includes the first voltage generator (108) and the first I/Q demodulator (114), the first voltage generator (108) and the first I/Q demodulator (114) are part of a first circuit separate from the integrated circuit (120), and wherein, when the quantum device (100) includes the second voltage generator (118) and the second I/Q demodulator (128), the second voltage generator (118) and the second I/Q demodulator (128) are part of a second circuit separate from the integrated circuit (120).

16. The quantum device (100) according to any one of the preceding claims, further including, when the data and measurement qubits (102), the inductor (104), the voltage amplifier (112), the first input terminal (122), and the output terminal (126) are made in the form of an integrated circuit (120), a cryostat configured to provide a closed space in which the temperature is equal to or less than 4 K, the integrated circuit (120) being arranged in the closed space of the cryostat.

FIG.1

FIG.2

FIG.3

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE FRANCESCHI S et al.** SOI technology for quantum information processing. *2016 IEEE IEDM*, 03 December 2016
- **A. CRIPPA et al.** Gate-reflectometry dispersive readout and coherent control of a spin qubit in silicon. *Nature Communications*, 2019, vol. 10
- **H. XIAO et al.** A 5.4-GHz high-Q tunable active-inductor bandpass filter in standard digital CMOS technology. *Analog Integrated Circuits and Signal Processing*, April 2007, vol. 51 (1), 1-9

- **F. BELMAS et al.** A New Method for Performance Control of a Differential Active Inductor for Low Power 2.4GHz applications. *2010 IEEE International Conference on Integrated Circuit Design and Technology, 2-4 juin 2010*, 02 June 2010
- **A.B. AMMADI**. Design of Wide-tuning High-Q Differential Active Inductor For Multistandard Applications. *2015 IEEE 12th International Multi-Conference on Systems, Signals & Devices (SSD15), 16-19 mars 2015*, 16 March 2015